Europäisches Patentamt

(19) European Patent Office

Office européen des brevets

(11) Publication number: **0 091 200**
**B1**

(12) EUROPEAN PATENT SPECIFICATION

(45) Date of publication of patent specification: 29.06.88

(51) Int. Cl.⁴: **G 06 F 1/04**

(21) Application number: 83301170.3

(22) Date of filing: 04.03.83

(54) Clock recovery apparatus.

(30) Priority: 05.04.82 US 365698

(43) Date of publication of application:
12.10.83 Bulletin 83/41

(45) Publication of the grant of the patent:
29.06.88 Bulletin 88/26

(84) Designated Contracting States:
DE FR GB

(56) References cited:
US-A-4 151 485

1979 INTERNATIONAL SYMPOSIUM ON
CIRCUITS AND SYSTEMS, PROCEEDINGS,
17th-19th July 1979, Tokyo, pages 804-805
MASATOSHI MAKINO et al.: " A
microprocessor-controlled phase-locked loop
for network synchronization

IBM TECHNICAL DISCLOSURE BULLETIN, vol.
19, no. 3, August 1976, pages 1108-1109, New
York, US T.G. COLE et al.: " Reference locked
variable-frequency generator "

(73) Proprietor: Laser Magnetic Storage
International Companý
4425 Arrows West Drive
Colorado Springs Colorado 80907 (US)

(72) Inventor: Carickhoff, Richard Charles
812 Pulaski Drive
Landsdale Pennsylvania 19446 (US)

(74) Representative: Miller, Joseph et al
J. MILLER & CO. Lincoln House 296-302 High
Holborn
London WC1V 7JH (GB)

(56) References cited:
PROCEEDINGS OF THE IEEE 1981 NATIONAL
AEROSPACE AND ELECTRONICS
CONFERENCE NAECON 1981, 19th-21st May
1981, Dayton Convention Center, vol. 1, pages
134-139, IEEE, New York, US M.A. EL-TANANY
et al.: " A fast carrier recovery circuit for CPFSK
signals"

## Description

This invention relates to clock recovery apparatus, and particularly to clock recovery apparatus employing both digital and analog techniques.

Clock recovery apparatus used in data processing generates clock signals in synchronism with input data. Principal objectives of clock recovery apparatus are that they perform synchronism with a minimum of phase jitter and a minimum lock range (as few clock cycles as possible), and are stable against drift and temperature changes.

Prior clock recovery apparatus employing analog techniques have been subject to instability due to temperature variations and due to problems associated with filters used for multiple data rate frequencies.

US—A—4151485 discloses a digital clock recovery circuit in which a digital clock signal tracks a pulse stream data signal by developing two phase-lock restorative voltages through a phase-locked loop circuit which control a loop voltage controlled oscillator that generates the clock signal, one fine voltage being developed through a digital up/down counter and a digital-to-analog converter whenever the phase difference between the two signals exceeds a first threshold, and the second coarse voltage being generated by combining with the fine voltage a voltage to reduce or increase its value before application to the voltage controlled oscillator so that the altered control voltage rapidly restores phase-lock whenever the phase difference exceeds a second threshold greater than the first. This provides that only if the predetermined phase difference of one data signal exceeds the threshold in the same direction as the predetermined phase difference of the preceding data signal exceeded the threshold, does a frequency alteration occur.

The present invention seeks to provide clock recovery apparatus employing both digital and analog techniques for clock recovery, thereby offering a stable, multi-range system.

Therefore, the present invention seeks to provide a clock recovery apparatus which is relatively stable against drift and temperature changes, does not require either filters or high frequency oscillators to obtain frequency synchronisation, as are used in digital systems which achieves synchronisation with minimum phase jitter, improved lock range, and a minimum access time, which can capture and track data frequencies over a wide frequency spectrum and which is capable of differentiating between frequency variation and asymmetry on the input data.

According to the present invention therefore, clock recovery apparatus for generating an output or reference clock signal locked to the phase and frequency of data pulse signals derived from a sequence of encoded input data signals, a voltage controlled oscillator responsive to an analog signal for generating a first clock signal having a frequency of oscillation representative of the value of the analog signal, phase detector means responsive to the data pulse signals and the first clock signals for determining the relative phase relationship therebetween and for generating appropriate control signals when the phase difference exceeds predetermined thresholds, up/down counter means for containing a count and operable by control signals from the phase detector means to increment or decrement the count, and a digital-to-analog converter means responsive to the count in the counter means for generating the analog signal to alter the operation of the oscillator to reduce the phase difference, characterised in that the phase detector means comprises memory means and register means being responsive to the memory means, a portion thereof being responsive to said first clock signals for cyclically counting the pulses thereof to generate the output or reference clock signal, and a further portion thereof providing a step count pulse and a pump-up signal to the counter means, the memory means being responsive to count in the register means, to the pump-up signal and to the data pulse signals to determine and store the phase difference between data pulse signals and the output or reference clock signals, so that, in operation, a signal representative of either a lead or a lag of such phase difference is stored in the memory means and register means, and if the phase difference exceeds a first threshold, the memory means operates to increment or decrement the count in the register means by a predetermined count, so that the register means provides a pump-up signal if the data pulse signal leads the output or reference clock signal, and provides said step count pulse if the phase difference between one data pulse signal and the output or reference clock signal is in the same direction as that between the preceding data pulse signal and the output or reference clock signal.

Preferably, the phase detector means generates a second output signal when the phase difference exceeds a second higher predetermined threshold, characterised in that the memory means is responsive to such a phase difference to increase the amount by which the count in the counter means is incremented or decremented.

In a preferred embodiment, the phase detector means generates a pump enable signal in response to the presence of a data pulse signal resultant from a data input signal, the absence of which disables the pump enable signal from altering the count in the counter means.

The apparatus preferably includes a second digital-to-analog converter means capable of producing a positive, a negative or a zero output, the second converter means being responsive to pump-up and pump enable signals to generate an output analog signal for addition to the analog signal from the first converter means, the representative of a phase difference to be reduced, the absence of the pump enable signal causing a zero output from the second converter means.

In this case, the second analog-to-digital converter means may be a ternary device, responsive to the enable signal and the first output signal from the phase detector means.

The invention is illustrated, merely by way of example, in the accompanying drawings, in which:—

Figure 1 is a block circuit diagram of one embodiment of a clock recovery apparatus according to the present invention;

Figure 2 is a block circuit diagram of a portion of the clock recovery apparatus illustrated in Figure 1;

Figures 3A, 3B and 4 are timing diagrams useful in explaining the operation of the clock recovery apparatus of Figure 1;

Figure 5 is a waveform illustrating the results achievable with a clock recovery apparatus according to the present invention;

Figures 6 and 7 are timing diagrams useful in explaining the accelerated mode of operation of a clock recovery apparatus according to the present invention; and

Figures 8A—E and 9A—9E are timing diagrams useful in explaining operation of a clock recovery apparatus according to the present invention for peak shift problems.

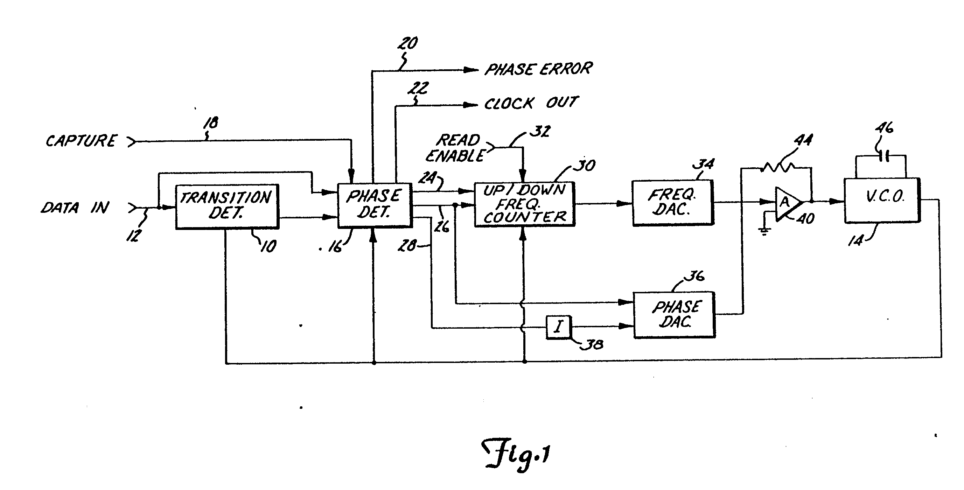

Referring to the drawings, particularly to Figure 1, there is illustrated a block circuit diagram of one embodiment of a clock recovery apparatus according to the present invention. The clock recovery apparatus includes a transition detector 10 having a first input for receiving an input data signal via a line 12, and a second input to receive a clock signal from a voltage controlled oscillator (VCO) 14. The transition detector 10 provides an output to a phase detector 16. The phase detector 16 also receives the input data signal from the line 12, and also receives the clock signal from the VCO 14 and a capture signal via a line 18. The phase detector 16 provides a phase error signal via a line 20, a clock output or reference clock signal via a line 22, a step count signal via a line 24, a pump up signal via a line 26 and a pump enable signal via a line 28. An up/down frequency counter 30 receives the step count signal and pump up signal from the phase detector 16 as well as the clock signal from the VCO 14. The counter 30 also receives a read enable signal via a line 32. A digital-to-analog (D/A) converter 34 receives the output of the counter 30 whereas a digital-to-analog (D/A) converter 36 receives the pump up signal and the pump enable signal from the phase detector 16. The D/A converter 34 is employed for frequency correction and control, and the D/A converter 36 is employed for phase correction and control. The pump enable signal is inverted by an inverter 38 prior to being fed to the D/A converter 36. The output of the D/A converters 34, 36 is provided as an input to an amplifier 40 which provides a voltage signal to the VCO 14. The function of the amplifier 40 is to convert the current derived by the D/A converters 34, 36 to a voltage signal for delivery to the VCO. The gain of the amplifier 40 may be adjusted by a resistor 44, and the nominal frequency of the VCO 14 may be controlled by a capacitor 46.

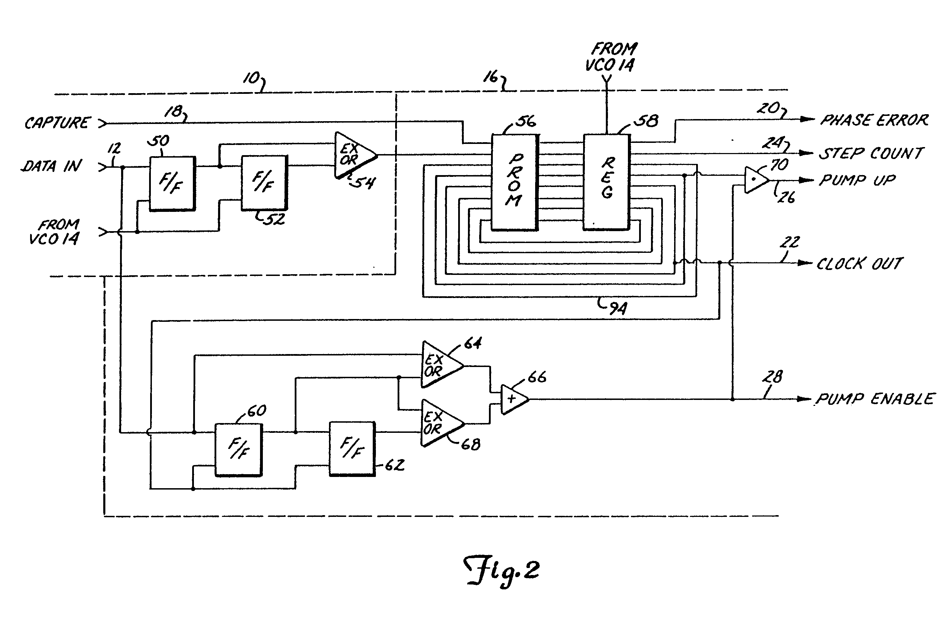

Figure 2 illustrates the transition detector 10 and the phase detector 16 in greater detail. The transition detector 10 comprises a pair of flip-flops 50, 52, the set input of the flip-flop 50 being connected to the line 12 to receive the input data signal and the set input of the flip-flop 52 being connected to the set output of the flip-flop 50. The clock inputs of the flip-flops 50, 52 are connected to the VCO 14. An EXCLUSIVE OR gate 54 receives inputs from the set outputs of the flip-flops 50, 52 and provides a data pulse signal to programmable read-only memory (PROM) 56 of the phase detector 16. The phase detector preferably comprises a 256 by 8 bit PROM 56 and a register 58 clocked by the VCO 14. The PROM 56 and the register 58 operating together generate a divide-by-16 count. The most significant bit of the divide-by-16 portion of the register 58 (the fourth lead thereof) provides the reference clock signal via the line 22. The fift output lead of the register 58 provides the pump up signal via the line 26, the seventh lead of the register 58 provides the step count signal via the lead 24, and the eighth or most significant output of the register 58 provides the phase error signal via the line 20. The clock signal from the register 58 also provides an input to clock inputs of flip-flops 60, 62. The set input of the flip-flop 60 is connected to the line 12 to receive the input data signal and the set input of the flip-flop 62 is connected to the set output of the flip-flop 60. An EXCLUSIVE OR gate 64 receives the data input signal from the line 12 and the set output of the flip-flop 60 and provides a first input to an OR gate 66. The second input to the OR gate 66 is provided from the output of an EXCLUSIVE OR gate 68 whose inputs are connected to receive the set outputs of the flip-flops 60, 62. The output of the OR gate 66 is provided via a line 28 to the D/A converter 36 and to an AND gate 70 to provide the pump up signal via the line 28 to both the counter 30 and the D/A converter 36.

In the data recording art, the term "data rate" is applied to the rate upon which data is transmitted. Data, which flows at a pre-established data rate, is reflected by transitions in an incoming signal. For example, a typical group code recording technique will employ a transition in the signal for each data cell containing a "1" bit and no transition for each data cell containing "0" bit, with the condition that there will be no more than two cells containing "0" bits in a row. Therefore, in such a group code recording technique, transitions will occur either at the data rate (consecutive "1" bits) or at half the data rate (a "1" bit followed by a "0" bit followed by a "1" bit), or at one-third the data rate (a "1" bit followed by two "0" bits followed by a "1" bit).

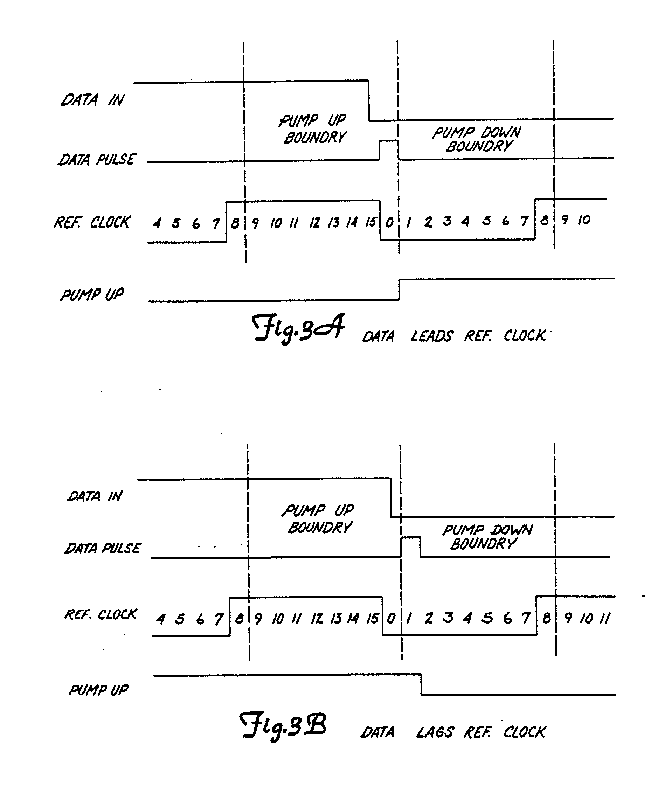

With the foregoing in mind, the operation of the clock recovery apparatus of Figure 1 will now be described. The VCO 14 provides a clock signal whose cycle rate is 16 times the data rate. The clock signal is provided to the transition detector 10 to provide a data pulse coincident with a clock signal from the VCO 14 immediately following (or coincident with) a data transition. As shown in Figure 3, the data transition might lead the reference clock signal on the line 22 (Figure 3A), or it might lag the reference clock signal (Figure 3B). The phase detector 16 detects the phase of the data transitions with respect to the reference clock signal and operates the D/A converters 34, 36 to adjust the frequency and phase of the VCO 14. Phase correction is accomplished by the D/A converter 36 independently of frequency correction, whereas frequency correction is accomplished by incrementing or decrementing the count of the counter 30 which controls the D/A converter 34 to establish the frequency of the VCO 14. Broadly, therefore, the phase detector 16 examines the relative position of the data pulse with reference to the clock signal and makes a decision as to whether or not to step the counter 30. As will be seen hereinafter, adjustment of frequency may require adjustment of phase, and vice versa.

The register 58 of the phase detector 16 is continuously stepped by the clock signal from the VCO 14 (which is operating at 16 times the rate of the reference clock signal). If the transition detector 10 detects a data transition out of phase with the reference clock signal, a signal representative of either a pump up or pump down condition is stored in the PROM 56 and the register 58. Depending upon how far removed the transition signal occurs from the phase of the reference clock signal, the PROM 56 may be programmed to provide a multiple step change in the counter 30 (to be hereinafter explained). The PROM 56 and the register 58 compare the relative phase of the current data cell transition with respect to the phase of the reference clock signal on the line 22 to provide a pump up or pump down signal to the counter 30 and the D/A converter 36 depending upon whether the transition leads or lags the reference clock signal.

The phase detector 16 determines the relative position of a data transition with respect to a pulse of the clock signal and compares that position with the position of the data transition of the previous data cell. If the position (phase shift) of the transition of the current cell is opposite that of the previous cell, the phase detector 16 does not initiate a change in the counter 30. However, if the positions of the data transition in both cells are relatively the same, then the phase detector will step the counter. In either case, the pump up signal delivered to both the counter 30 and the D/A converter 36 will reflect the direction of the transition removal. Thus, update of the counter is delayed one cell to provide single cell hysteresis and improve the accuracy of the frequency of the reference clock signal.

With reference to Figures 3A and 3B, the pump up and pump down aspects of the phase detector 16 may be explained. A data pulse occurring during counts 9 to 15 and 0 of the clock signal from the VCO 14 is treated by the phase detector 16 as a pump up condition, whereas a data pulse occurring during counts 1 to 8 is treated as a pump down condition. Therefore, in Figure 3A, the data transition leads the reference clock signal causing the data pulse from the transition detector 10 to occur in the pump up boundary condition. In Figure 3B the data lags the clock signal causing the data pulse to occur in the pump down boundary thereby causing a pump down condition. Successive data pulses occurring in opposite boundaries will require no frequency change whereas successive data pulses occurring in the same boundary requires a frequency change. As explained above, the phase detector 16 detects the need for a frequency change and operates the counter 30 accordingly.

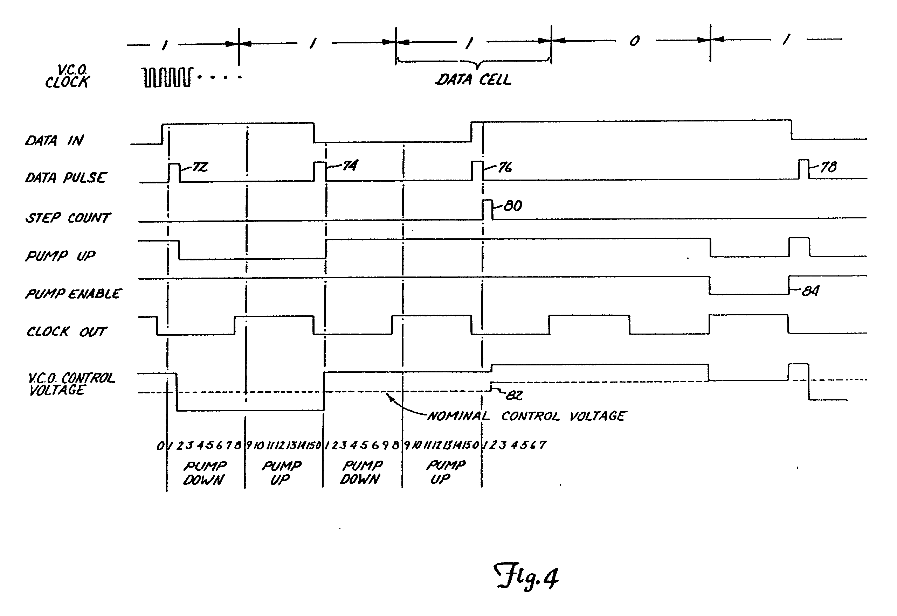

With reference to Figure 4, the frequency correction aspects of the clock recovery apparatus will be explained. As heretofore explained, pulses of the input data signal will occur in either the pump up or pump down boundary. Thus, in Figure 4 data pulses 72, 78 are in the pump down boundary, whereas pulses 74, 76 are in the pump up boundary. The PROM 56 and the register 58 sense the position of the data pulses and produce a pump up signal, essentially as shown in Figure 4. (As will be explained hereinafter, the pump up signal developed by the PROM 56 and the register 58 is logically ANDed with the pump enable signal for phase control. Thus, Figure 4 actually illustrates the pump up signal after logically ANDing. The pump up signal developed by the PROM 56 and the register 58 actually follows the boundary condition of the data pulses). Since the pulses 74, 76 are consecutively in the pump up region, the PROM 56 and the register 58 sense the fact that the phase shift of both pulses is in the same direction and initiate the step count signal, shown as a pulse 80. The pump up signal and the step count signal are delivered to the counter 30.

The counter 30 is preferably a 7-bit counter having its most significant bit preset to "1" and all other bits set to "0". This will provide a frequency accuracy of 0.5% over a frequency range of ±32%. The counter is initialised by the read enable signal to preset the counter to an established position.

The counter 30 senses the pump up signal and the step count signal from the phase detector 16 and increments or decrements the count in the counter by the number of step count pulses in the step count signal and in the direction dictated by the condition of the pump up signal. In the example shown in Figure 4, when the pump up signal is high, the count in the counter 30 is advanced. (If the consecutive data pulses were in the pump down boundary, the pump up signal would be low when the step count signal is generated, thereby causing a decrement in the count in the counter 30.) During each clock cycle of the VCO 14, the count of the counter 30 is presented to the D/A converter 34 as a digital count of the frequency. Therefore, a change in the count stored in the counter 30 causes a corresponding change in the digital signal. When the count in the counter 30 is advanced by one count, the digital signal to the D/A converter 34 is also advanced, thereby causing an increase in the control voltage to the VCO 14, as indicated by reference numeral 82.

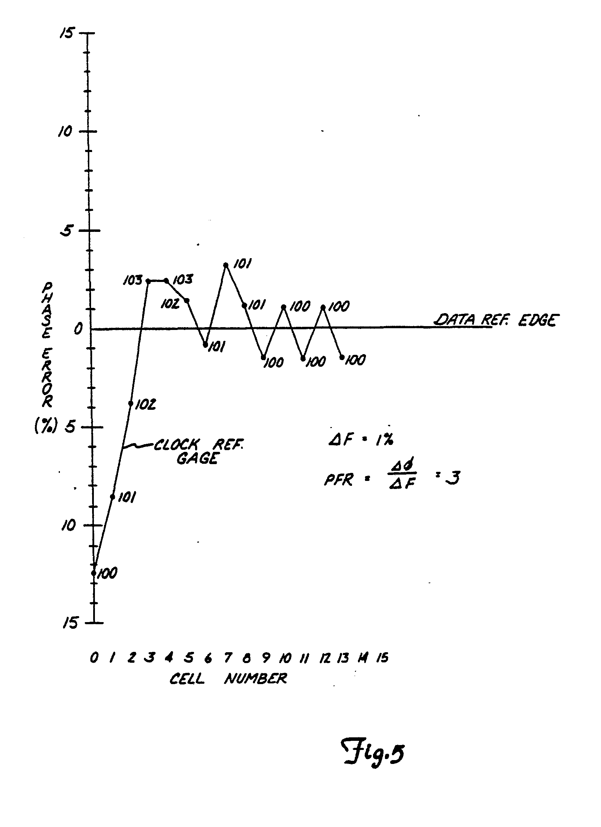

Without phase correction, the clock recovery apparatus would operate such as to deliver a control voltage shown in the broken line in Figure 4. However, the phase converter 36 is provided as a damping factor to stabilise the clock recovery apparatus, and the phase component or correction is added to the frequency correction to control the VCO 14. Experimentation indicates that a phase-to-frequency correction ratio (PFR) between 2 and 3 is optimum, with best results achieved with PFR=2.5. It can be shown that for PFR ratios of less than about 2 (PFR<2) the system will be somewhat underdamped, whereas for PFR ratios greater than about 4 (PFR>4) the systems will be somewhat overdamped. Figure 5 illustrates the effect of damping, using a PFR ratio of 3.0. As indicated in Figure 5, with PFR=3 and a frequency of 100, a phase shift of 12.5% is corrected within about 10 cells. For a frequency increment of 0.5%, the phase correction should be ±1.25% with a PFR=2.5.

As shown in Figure 4, the pump up signal generated by the register 58 essentially follows the condition of the data pulses. Therefore, with the pulse 72 in the pump down boundary, the pump up signal goes low; with the pulses 74, 76 in the pump up boundary, the pump up signal goes and remains high; with the pulse 78 in the pump down boundary, the pump up signal goes low. However, the pump up signal delivered to the counter 30 and the D/A converter 36 is logically ANDed with the pump enable signal by the AND gate 70. The pump enable signal is generated by the gates 64, 66, 68 and the flip-flops 60, 62, the arrangement being that the pump enable signal is high at all times except that it is triggered low by the reference clock signal following a "0" bit cell. Hence, the pump enable signal goes low as shown by reference numeral 84, thereby driving the pump up signal to a low condition. The pump up signal goes high upon return of the high condition of the pump enable signal and goes low with the data pulse 78 in the pump down boundary. (If the pulse 78 were in the pump up boundary, the pump up signal would remain high and another step count signal would be generated to advance again the count in the counter 30).

The D/A converter 36 is essentially a ternary device; that is, it may assume any of three states: (1) a positive current output, (2) a zero output or (3) a negative current output. If the pump enable signal is high, the output of the D/A converter 36 will be either positive or negative, depending upon whether the pump up signal is high or low. However, if the pump enable signal is low, the output of the D/A converter 36 is zero, regardless of the state of the pump up signal. Since the pump enable signal is low during drift conditions of no data transitions (data values of "0"), the D/A converter 36 is disabled, in essence, by the low pump enable signal to permit the clock recovery apparatus to coast until data transitions resume.

As shown in Figure 4, the actual control voltage to the VCO 14 assumes any of three values: the nominal voltage established by the D/A converter 34 (i.e., when the pump enable signal is low), an upper voltage caused by the nominal voltage plus that added to it by a pump up condition sensed by the D/A converter 36, and a lower voltage caused by the nominal voltage less that subtracted from it by a pump down condition sensed by the D/A converter 36. It will be appreciated that the phase of the reference clock signal is altered with the frequency of the VCO by increasing or decreasing the frequency of the VCO for one cell. Further, when the frequency is locked to the data, the phase control alternately and essentially equally advances and retards about the synchronised phase.

One feature of the clock recovery apparatus resides in the accelerated synchronisation of the reference clock signal to the incoming data rate. This is accomplished by setting the capture signal on the line 18 and by the phase detector 16, and particularly the PROM 56 and the register 58, sensing the input data signal more than 6.25% out of synchronism with the clock signal. As heretofore explained, the lower four outputs of the register 58 act as a counter, counting up to 16 counts for each reference clock cycle, the count output of the register 58 cooperating with the PROM 56 to establish the reference count and the pump up and pump down boundaries illustrated in Figures 3 and 4. Thus, if as illustrated in Figures 3A, the data leads the reference clock signal, the data pulse generated by the transition detector 10 causes the PROM 56 and the register 58 to generate a pump up signal, whereas if the data lags the reference clock signal, a pump down signal is generated (Figure 3B). The conditions illustrated in Figures 3 and 4 are conditions where the data is less than 6.25% out of synchronism with the reference clock signal; namely, when the data pulse occurs in either the "0" (pump up) or "1" (pump down) reference count.

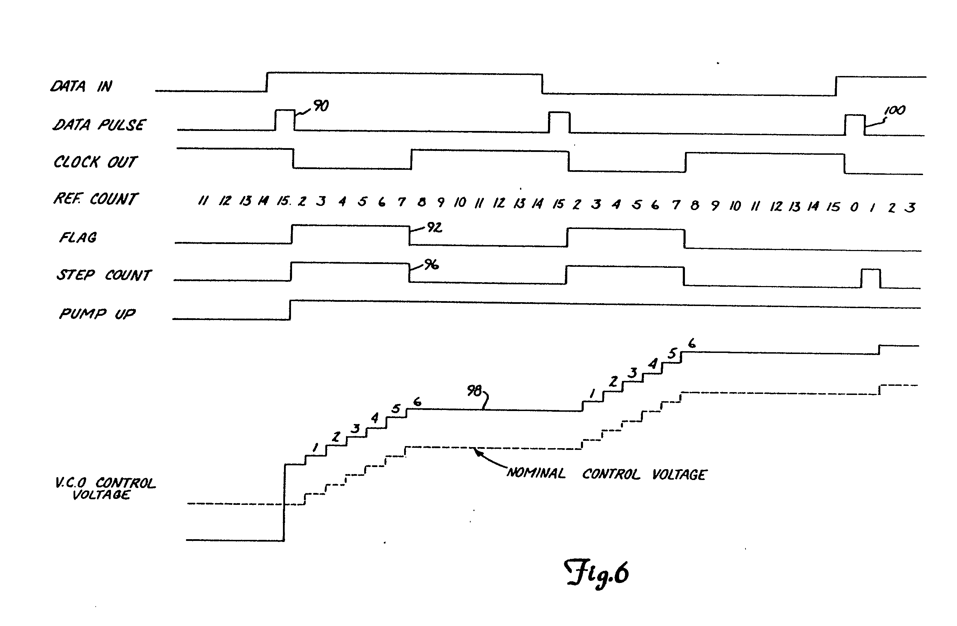

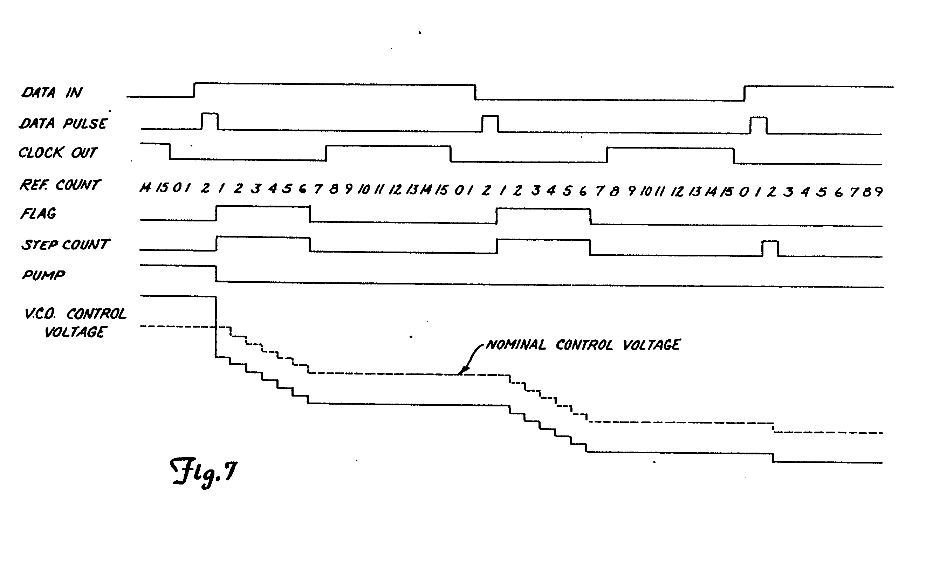

Figures 6 and 7 illustrate the manner of accelerated synchronization. In Figure 6, the data leads the reference clock signal by more than 6.25%. Specifically, the data in Figure 6 is leading the clock signal so that data pulse 90 generated by the transition detector 10 is in count "15" of the reference count within the register 58. The PROM 56, receiving the pulse 90 from the transition detector 10 and the count from the register 58 senses the coincidence of the pulse 90 in count "15" and causes the register 58 to set a flag signal 92 on a line 94 (Figure 2). The flag signal from the PROM 56 also forces the counter portion of the register 58 to a count of "2" (regardless of the previous count) and forces the pump up signal to a set or high condition. In addition, the PROM 56 sets the step count signal 96 to a high condition for six cycles of the clock signal of the VCO. With the pump up signal high and the pump control signal high for a period of six counts, the count in the counter 30 is advanced by six thereby increasing a control voltage signal 98 to the VCO 14. As shown in Figure 6, the control voltage signal is increased with each clock cycle of the VCO during the six counts that the step count signal 96 is high. When, as shown in Figure 6, the clock is within 6.25% of the data, the operation will revert to its normal operation hereinabove described. Thus, data pulse 100 is located in the "0" count, indicating the data still leads the clock, but by less than 6.25%, thereby causing an advance of only one step (0.5%) in the frequency of the clock signal of the VCO 14.

Similarly, as shown in Figure 7, if the data lags the clock signal by more than 6.25% (e.g., the data pulse is in reference count "2"), the PROM 56 sets the flag and step count signals as heretofore described and sets the pump up signal to a low condition (indicating a pump down condition), thereby causing a decrement of the count in the counter 30 by a count of six and a corresponding decrease in the control voltage signal to the VCO 14. Also, the PROM 56 forces the count in the register 58 to a count of "1" (regardless of the previous count). Again, when the data pulse from the transition detector 10 is again in the "1" count (indicating synchronism to within 6.25%), the clock recovery apparatus reverts to its normal operation hereinbefore described.

As hereinbefore described, it is preferred that the D/A converter 36 provides an adjustment which is about 2.5 times the correction provided by the D/A converter 34. Therefore, during normal operations, a single step of the counter 30 will cause a 0.5% change in frequency of the clock signal of the VCO 14 and a corresponding 1.25% change in phase is generated by the D/A converter 36. During accelerated synchronisation of the reference clock signal, a frequency shift of 3.0% is caused by a step of six counts as described in connection with Figures 6 and 7, and a phase shift of 7.5% is generated (6.25% shift caused by advancing or retarding the count in the register 58 and 1.25% caused by the D/A converter 36). Thus, stability is maintained by maintaining the PFR at 2.5.

It will be appreciated that the accelerated frequency synchronisation achieves synchronisation in less time than without the accelerated feature. Thus, without the accelerated feature, a frequency difference of 32% would require 64 data cells to achieve synchronisation, whereas with the acceleration feature only 21 cells, or data transitions are required for frequency synchronisation: 9 cells at 3% correction per cell and 12 cells at 0.5% correction. Once synchronisation is achieved, the capture signal is removed for normal operation.

The algorithm within the PROM 56 may be summarised, for the accelerated (capture) function, as follows:

TABLE I—Data acquisition algorithm
A. If the data pulse from the transition detector 10 occurs during reference count "0",

1. Set pump up signal high, and
2. Set step count signal for one clock cycle of the VCO if pump up signal was already high from previous data pulse.

B. If the data pulse from the transition detector 10 occurs during reference count "1",
1. Reset pump up signal low, and
2. Set step count signal for one clock cycle of the VCO if pump up signal was already low from previous data pulse.

C. If the data pulse from the transition detector 10 occurs during reference counts "2" to "8",
1. Reset pump up signal low,
2. Set flag signal for six clock cycles of the VCO,
3. Force count in the register 58 to "1", and
4. Set step count signal for duration of flag signal.

D. If the data pulse from the transition detector 10 occurs during reference counts "9" to "15",
1. Set pump up signal high,
2. Set flag signal for six clock cycles of the VCO,
3. Force count in the register 58 to "2", and
4. Set step count signal for duration of flag signal.

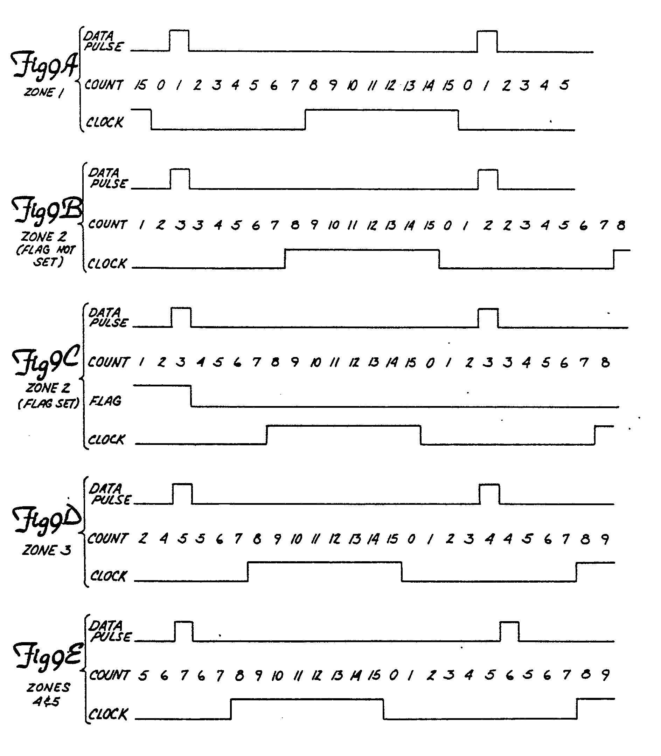

The description thus far has been concerned with data not containing peak shift. Data recorded on magnetic tape contains a certain amount of peak shift, the amount being a function of the encoding technique and method of recording. For example, peak shift may be quite severe in group code recording (GCR). Peak shift normally occurs on data transitions that surround zero data cells. Low amplitude data due to a temporary drop out can generate peak shift on all transitions. Up stream and down stream shift, caused by the data pattern changing between a high frequency pattern (ones) and a low frequency pattern (zeros) can affect peak shift. The present invention provides for peak shift correction through the use of special algorithms in the PROM 56. For data recovery in magnetic tape, it is preferred to divide the pump up and pump down boundaries into five zones (instead of two heretofore described): For the pump down boundary, the five zones are (1) count "1" (indicating less than 6.25% phase shift, (2) counts "2" and "3" (indicating a phase shift between 6.25% and 18.75%), (3) counts "4" and "5" (indicating a phase shift between 18.75% and 31.25%), (4) counts "6" and "7" (indicating a phase shift between 31.25% and 43.75%), and (5) count "8" indicating a phase shift between 43.75% and 50%). Similarly the five zones of the pump up boundary are (1) count "0", (2) counts "14" and "15", (3) counts "12" and "13", (4) counts "10" and "11", and (5) count "9". It is desired, for the first zone (counts "0" or "1") the decision to make a correction is based on the conditions of the previous cycle as heretofore described. For the second zone (counts "2", "3", "14" or "15") it is desired to phase shift by 6.25% if the flag signal is not set. For the third zone (counts "4", "5", "12" and "13") a phase shift of 6.25% is desired, whereas during the fourth and fifth zones (counts "6" to "11") a phase shift of 12.5% is desired. In addition, for the fifth zone (counts "8" and "9") an error signal should be generated to alert external equipment of a peak shift error approaching 50%. In addition, a frequency shift of 0.5% is desired for phase shift accomplished. Figures 8A—8E and 9A—9E illustrate the operation of the clock recovery apparatus.

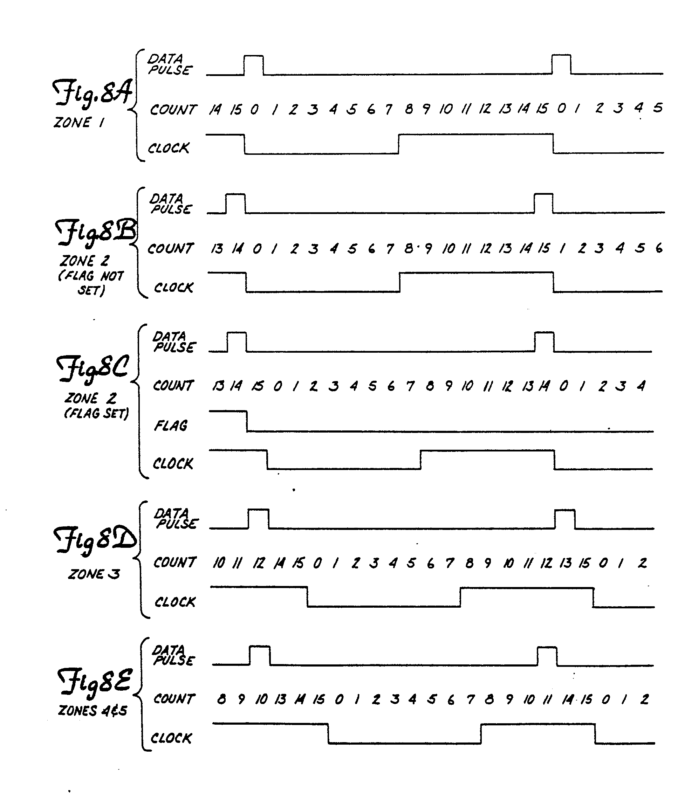

Whenever the PROM 56 detects a data pulse from the transition detector 10 within any of counts "4" to "13" (indicating a phase shift greater than 18.75%) the PROM causes the flag signal to be set. The flag signal remains set until cleared as hereinafter explained. In addition, if the data pulse occurs in counts "12" or "13", the PROM 56 causes the count within the register 58 to advance by one additional count (Figure 8D), whereas if the data pulse occurs in counts "4" or "5", the PROM 56 causes the count with the register 58 to retard by one count (actually, to hold its count for one clock cycle of the VCO, as shown in Figure 9D. Likewise, if the data pulse occurs in counts "6" to "8" or "9" to "11", the count in the register 58 is advanced or retarded by two counts (Figures 8E and 9E). Also, if the data pulse occurs in either count "8" or "9" the PROM 56 causes the register 58 to place a phase error signal on the line 20 (Figures 1 and 2). The phase error signal is employed to alert the system that peak shift error is between 43.75% and 50%.

If the data pulse is within counts "2", "3", "14" or "15", the PROM 56 advances or retards the count in the register 58 by one count only if the flag signal is not set. If the flag is set (e.g. from a previous cell wherein the data pulse occurred within counts "4" to "13"), the count within the register 58 is advanced or retarded only if the direction of the data pulse is the same as the previous cell. If the direction is opposite that of the previous cell, the count in the register 58 is incremented as in normal operation. This is illustrated in Figures 8B, 8C, 9B and 9C wherein the count is advanced by one count for pump up conditions and retarded for one count for pump down conditions if the flag is not set. Also, the PROM 56 resets the flag signal in zone 1 and 2 conditions if the pump up or pump down condition is opposite that of the previous cell. Therefore, if the flag is set during a severe pump up condition (e.g. counts "9" to "13"), and a pump up condition is sensed in counts "14" or "15", the flag is not reset. The flag signal will be reset only when a reversal of the pump up or pump down condition is sensed. If the flag is set and a reversal condition is sensed, a data pulse in count "2", "3", "14" or "15" will not advance or retard the count in the register 58. See particularly Figures 8C and 9C, and particularly the left-hand data pulse thereof.

If the data pulse occurs in cells "0" or "1", only the incrementing of the count in the register 58 will occur. If the flag was previously set, it will be reset if the pump up or pump down condition is opposite that of the previous cycle.

As will be appreciated by inspection of Figures 8 and 9, each addition or subtraction of the count in the register 58 serves to alter the phase of the clock signal by 6.25%.

During each correction cycle, a single step count signal is generated to step the count in the counter 30 by one count, in accordance with the condition of the pump up signal. However, unlike the conditions given in respect to Figures 6 and 7, only a single step to the frequency counter is achieved. Therefore, a phase correction of up to 13.75% is achievable with only a 0.5% frequency shift. Hence, a frequency shift of 0.5% will employ a corresponding 1.25% phase shift by the D/A converter 36 (using PFR=2.5) plus up to 12.5% phase shift by the phase detector 16. The algorithm for data recovery for magnetic tape is summarised in Table II.

TABLE II—Data recovery algorithm for magnetic tape

A. If the data pulse from the transition detector 10 occurs during reference counts "6" to "11",
   1. Set pump up signal to proper direction (low for "6" to "8" and high for "9" to "11"),
   2. Set flag signal,
   3. Generate a 12.5% phase correction by adding 2 counts to the register 58 for "9" to "11' or subtracting 2 counts from the register 58 for "6" to "8",
   4. Set step count signal for one clock cycle of the VCO, and
   5. Set phase error signal for "8" or "9".

B. If data pulse from transition detector 10 occurs during reference counts "4", "5", "12" or "13".
   1. Set pump up signal to proper directions,
   2. Set flag signal,
   3. Generate a 6.25% phase correction by adding 1 count to the register 58 for "12" or "13" or subtracting 1 count from the register 58 for "4" or "5", and
   4. Set step count signal for one clock cycle of the VCO.

C. If data pulse from the transition detector 10 occurs during reference count "2", "3", "14" or "15",
   1. Set pump up signal to proper direction,
   2. Generate a 6.25% phase correction by adding or subtracting one count in the register 58 if either (a) the flag is not set, or (b) the flag is set and the pump up or pump down condition is the same as the previous data transition.
   3. Set step count signal for one clock cycle of the VCO if pump up or pump down condition is same as that of the previous data transition, and
   4. Reset flag signal if pump up or pump down condition is opposite that of the previous data transition.

D.  If data pulse from the transition detector 10 occurs during reference counts "0" or "1",
1.  Set pump up signal to proper direction,
2.  Set step count signal for one clock cycle of the VCO if pump up or pump down condition is same as that of the previous data transition, and
3.  Reset flag signal if pump up or pump down condition is opposite that of the previous data transition,

One feature of the present invention resides in the fact that the clock recovery apparatus may be utilised to recover multiple data rate frequencies without the use of separate filters as may be required in analog phase-lock loop circuits. Thus, the clock signal from the VCO is divided to derive the output clock, without disturbing the stability of the system. Phase and frequency corrections are based on percentage of the data cell. Dividing the clock signal from the VCO lowers the reference clock signal to serve multiple of the clock signal of the VCO without affecting the percentage correction.

As herein described, the D/A converter 36 is a ternary device which provides a ±1.25% phase shift. In reality, the D/A converter 36 may be an 8-bit, using only two bit positions. If desired, other bit positions of the D/A converter 36 may be used to achieve multiples of 1.25% phase correction. For example, if five of the bit positions of the D/A converter 36 were used, the D/A converter 36 could be used to achieve any multiple of 1.25% phase shift, up to 18.75%. Therefore, the D/A converter 36 could be employed to generate desired 6.25% and 12.5% phase shifts. However, to employ the D/A converter 36 to operate additional bit positions, the register 58 of the phase detector 16 would need to be correspondingly enlarged with a separate register output driving each additional bit position input of the D/A converter 36. Also, additional programming in the PROM 56 will be required to accomplish phase correction in the D/A converter 36 instead of in the register 58.

The clock recovery apparatus is a general purpose clock recovery apparatus which can be used to recover clock signals from any input data stream. The recovery algorithm stored in the PROM of the phase detector may be refined for different input data streams. The clock recovery apparatus according to the present invention, being a digital system in its frequency selection, does not exhibit the instability, drift and temperature problems associated with analog phase-lock loop circuits. Instead, clock frequency is controlled by the contents of the counter 30. If data drops out, frequency will not drift or change. Nor does the clock recovery apparatus require high frequency oscillators to obtain accurate frequency synchronisation. Instead, the VCO operated in conjunction with the counter 30 provide 0.25% frequency accuracy with only an 8-bit counter and still achieve a frequency rate of ±32%.

The clock recovery apparatus according to the present invention and described above is effective in operation, inexpensive to manufacture and operate and is more stable than previous clock recovery apparatus, achieving synchronisation with a minimum of jitter, improved lock range, and minimum access time.

**Claims**

1.  Clock recovery apparatus for generating an output or reference clock signal (22) locked to the phase and frequency of data pulse signals derived from a sequence of encoded input data signals (12), a voltage controlled oscillator (14) responsive to an analog signal for generating a first clock signal having a frequency of oscillation representative of the value of the analog signal, phase detector means (16) responsive to the data pulse signals and the first clock signals for determining the relative phase relationship therebetween and for generating appropriate control signals when the phase difference exceeds predetermined thresholds, up/down counter means (30) for containing a count and operable by control signals from the phase detector means to increment or decrement the count, and a digital-to-analog converter means (34) responsive to the count in the counter means for generating the analog signal to alter the operation of the oscillator (14) to reduce the phase difference, characterised in that the phase detector means (16) comprises memory means (56) and register means (58) being responsive to the memory means, a portion thereof being responsive to said first clock signals for cyclically counting the pulses thereof to generate the output or reference clock signal (22), and a further portion thereof providing a step count pulse (24) and a pump-up signal (26) to the counter means (30), the memory means (56) being responsive to count in the register means (58), to the pump-up signal (26) and to the data pulse signals to determine and store the phase difference between data pulse signals and the output or reference clock signals (22), so that, in operation, a signal representative of either a lead or a lag of such phase difference is stored in the memory means and register means, and if the phase difference exceeds a first threshold, the memory means operates to increment or decrement the count in the register means by a predetermined count, so that the register means provides a pump-up signal (26) if the data pulse signal leads the output or reference clock signal (22), and provides said step count pulse (24) if the phase difference between one data pulse signal and the output or reference clock signal is in the same direction as that between the preceding data pulse signal and the output or reference clock signal.

2.  Apparatus as claimed in claim 1, in which the phase detector means (16) generates a second output signal when the phase difference exceeds a second higher predetermined threshold, characterised in that the memory means (56) is responsive to such a phase difference to increase the amount by which the count in the counter means (30) is incremented or decremented.

3. Apparatus according to claim 1 or 2, further characterised in that the phase detector means (16) generates a pump enable signal (28) in response to the presence of a data pulse signal resultant from a data input signal, the absence of which disables the pump enable signal from altering the count in the counter means.

4. Apparatus according to claim 1, 2 or 3, further characterised by a second digital-to-analog converter means (36) capable of producing a positive, a negative or a zero output, the second converter means (36) being responsive to pump-up and pump enable signals (26, 28) to generate an output analog signal for addition to the analog signal from the first converter means (34), the representative of a phase difference to be reduced, the absence of the pump enable signal (28) causing a zero output from the second converter means (36).

5. Apparatus as claimed in claim 4, as appendant to claim 3, characterised in that the second digital-to-analog converter means (36) is a ternary device, responsive to the enable signal and the first output signal from the phase detector means (16).

**Patentansprüche**

1. Vorrichtung zur Taktwiederherstellung zur Erzeugung eines Ausgangs- oder Bezugs-Taktsignals (22), das phasen- und frequenzstarr auf Datenimpulssignale bezogen ist, die von einer Folge von codierten Eingangsdatensignalen (12) abgeleitet werden, mit einem spannungsgesteuerten Oszillator (14), der auf ein Analogsignal anspricht, um ein erstes Taktsignal mit einer Schwingungsfrequenz zu erzeugen, die den Wert des Analogsignals darstellt, mit einer Phasendetektoreinrichtung (16), die auf die Datenimpulssignale und die ersten Taktsignale anspricht, um die relative Phasenbeziehung zwischen diesen Signalen zu bestimmen und um entsprechende Steuersignale zu erzeugen, wenn die Phasendifferenz vorgegebene Schwellwerte überschreitet, eine Vorwärts-/Rückwärts-Zählereinrichtung (30), die eine Zählung enthalten kann und durch Steuersignale von der Phasendetektoreinrichtung betätigbar ist, um die Zählung zu vergrößern oder zu verkleinern, und mit einer Digital-/Analog-Konvertereinrichtung (34), die auf die Zählung in der Zählereinrichtung anspricht und das Analogsignal erzeugt, um die Betriebsweise des Oszillators (14) derart zu ändern, daß die Phasendifferenz verringert wird, dadurch gekennzeichnet, daß die Phasendetektoreinrichtung (16) Speichereinrichtungen (56) und auf die Speichereinrichtungen ansprechende Registereinrichtungen (58) umfaßt, von denen ein Teil auf die genannten ersten Taktsignale anspricht, um zyklisch deren Impulse zu zählen, um das Ausgangs- oder Bezugs-Taktsignal (22) zu erzeugen, während ein weiterer Teil hiervon einen Schrittzählimpuls (24) und ein Aufwärts-Pumpsignal (26) an die Zählereinrichtung (30) liefert, daß die Speichereinrichtungen (56) auf die Zählung in den Registereinrichtungen (58), das Aufwärts-Pumpsignal (26) und auf die Datenimpulssignale ansprechen, um die Phasendifferenz zwischen Datenimpulssignalen und den Ausgangs- oder Bezugs-Taktsignalen (22) zu bestimmen und zu speichern, sodaß im Betrieb ein entweder eine Voreilung oder eine Nacheilung einer derartigen Phasendifferenz darstellendes Signal in den Speichereinrichtungen und den Registereinrichtungen gespeicehert ist, und daß, wenn die Phasendifferenz einen ersten Schwellwert überschreitet, die Speichereinrichtungen eine Vergrößerung oder Verkleinerung der Zählung in den Registereinrichtungen um eine vorgegebene Zählung bewirken, sodaß die Registereinrichtungen ein Aufwärts-Pumpsignal (26) liefern, wenn das Datenimpulssignal dem Ausgangs- oder Bezugs-Taktsignal (22) voreilt, während die Registereinrichtungen einen Schrittzählimpuls (24) liefern, wenn die Phasendifferenz zwischen einem Datenimpulssignal und dem Ausgangs- oder Bezugs-Taktsignal in der gleichen Richtung wie die Phasendifferenz zwischen dem vorhergehenden Datenimpulssignal und dem Ausgangs- oder Bezugs-Taktsignal verläuft.

2. Vorrichtung nach Anspruch 1, bei der die Phasendetektoreinrichtung (16) ein zweites Ausgangssignal erzeugt, wenn die Phasendifferenz einen zweiten höheren vorgegebenen Schwellwert übersteigt, dadurch gekennzeichnet, daß die Speichereinrichtung (56) auf eine derartige Phasendifferenz anspricht, um den Wert zu erhöhen, um den die Zählung in den Zählereinrichtungen (30) vergrößert oder verkleinert wird.

3. Vorrichtung nach Anspruch 1 oder 2, dadurch gekennzeichnet, daß die Phasendetektoreinrichtung (16) ein Pump-Freigabesignal (28) in Abhängigkeit von dem Vorhandensein eines sich aus einem Dateneingangssignal ergebenden Datenimpulssignals erzeugt, wobei das Fehlen eines Datenimpulsssignals das Pump-Freigabesignal an einer Änderung der Zählung in der Zählereinrichtung hindert.

4. Vorrichtung nach Anspruch 1, 2 oder 3, dadurch gekennzeichnet, daß eine zweite Digital-/Analog-Konvertereinrichtung (36) vorgesehen ist, die einen positiven Ausgang, einen negativen Ausgang oder einen Ausgang von Null liefern kann, daß die zweite Konvertereinrichtung (36) auf die Aufwärts-Pump- und Pumpfreigabesignale (26, 28) anspricht, um ein Ausgangs-Analogsignal zu erzeugen, das zu dem Analogsignal von der ersten Konvertereinrichtung (34) hinzuaddiert wird, das eine zu verringernde Phasendifferenz darstellt, und daß das Fehlen des Pump-Freigabesignals (28) ein Null-Ausgangssignal von der zweiten Konvertereinrichtung (36) hervorruft.

5. Vorrichtung nach Anspruch 4, unter Rückbeziehung auf Anspruch 3, dadurch gekennzeichnet, daß die zweite Digital-/Analog-Konvertereinrichtung (36) ein ternäres Bauteil ist, das auf das Freigabesignal und das erste Ausgangssignal von der Phasendetektoreinrichtung (16) anspricht.

## Revendications

1. Appareil de restauration d'horloge destiné à produire un signal d'horloge de sortie, ou de référence, (22) verrouillé sur la phase et la fréquence de signaux d'impulsion de données extraits d'une séquence de signaux de données d'entrée codés (12), un oscillateur à commande par tension (14) répondant à un signal analogique en produisant un premier signal d'horloge qui possède une fréquence d'oscillation représentative de la valeur du signal analogique, un moyen détecteur de phase (16) répondant aux signaux d'impulsion de données et aux premiers signaux d'horloge en déterminant la relation de phase respective existant entre eux et en produisant des signaux de commande appropriés lorsque le déphasage dépasse des seuils prédéterminés, un moyen compteur ascendant-descendant (30) servant à contenir une valeur de comptage et pouvant être actionné par des signaux de commande venant du moyen détecteur de phase afin d'incrémenter ou de décrémenter la valeur de comptage, et un moyen convertisseur numérique-analogique (34) répondant à la valeur de comptage contenue dans le moyen compteur en produisant le signal analogique afin de modifier le fonctionnement de l'oscillateur (14) de manière à réduire le déphasage, caractérisé en ce que le moyen détecteur en phase (16) comprend un moyen de mémoire (56) et un moyen de registre (58) qui répond audit moyen de mémoire, une partie de celui-ci répondant auxdits premiers signaux d'horloge en comptant cycliquement les impulsions de ceux-ci afin de produire le signal d'horloge de sortie, ou de référence, (22), et une autre partie de celui-ci produisant une impulsion de comptage de pas de progression (24) et un signal de pompage positif (26) à destination du moyen compteur (30), le moyen de mémoire (56) répondant à la valeur de comptage contenue dans le moyen de registre (58), au signal de pompage positif (26) et aux signaux d'impulsion de données de manière à déterminer et à emmagasiner le déphasage présent entre les signaux d'impulsion de données et les signaux d'horloge de sortie, ou de référence, (22), de sorte que, en fonctionnement, un signal représentatif d'une avance ou d'un retard de ce déphasage est emmagasiné dans le moyen de mémoire et le moyen de registre, et, si le déphasage excède un premier seuil, le moyen de mémoire agit pour incrémenter ou décrémenter la valeur de comptage contenue dans le moyen de registre d'une valeur de comptage prédéterminée, de sorte que le moyen de registre fournit un signal de pompage positif (26) si le signal d'impulsion de données est en avance sur le signal d'horloge de sortie, ou de référence, (22), et fournit ladite impulsion de comptage de pas de progression (24) si le déphasage entre un signal d'impulsion de données et le signal d'horloge de sortie, ou de référence, est dans le même sens que celui présent entre le signal d'impulsion de données précédent et le signal d'horloge de sortie, ou de référence.

2. Appareil selon la revendication 1, dans lequel le moyen détecteur de phase (16) produit un deuxième signal de sortie lorsque le déphasage dépasse un deuxième niveau prédéterminé supérieur, caractérisé en ce que le moyen de mémoire (56) répond à un tel déphasage en augmentant la quantité dont la valeur de comptage contenue dans le moyen compteur (30) est incrémentée ou décrémentée.

3. Appareil selon la revendication 1 ou 2, caractérisé en outre en ce que le moyen détecteur de phase (16) produit un signal de validation de pompage (28) en réponse à la présence d'un signal d'impulsion de données résultant d'un signal d'entrée de données, dont l'absence invalide le signal de validation de pompage en empêchant la modification de la valeur de comptage contenue dans le moyen compteur.

4. Appareil selon la revendication 1, 2 ou 3, caractérisé en outre par un deuxième moyen convertisseur numérique-analogique (36) susceptible de produire un signal de sortie positif, négatif ou nul, le deuxième moyen convertisseur (36) répondant à des signaux de pompage positif et de validation de pompage (26, 28) de manière à produire un signal analogique de sortie en vue de son addition au signal analogique venant du premier moyen convertisseur (34), représentatif d'un déphasage à réduire, l'absence du signal de validation de pompage (28) provoquant un signal de sortie nul de la part du deuxième moyen convertisseur (36).

5. Appareil selon la revendication 4, lorsque celle-ci est liée à la revendication 3, caractérisé en ce que le deuxième moyen convertisseur numérique-analogique (36) est un dispositif ternaire, répondant au signal de validation et au premier signal de sortie du moyen détecteur de phase (16).

Fig.1

Fig.2

**0 091 200**

Fig.3A   DATA LEADS REF. CLOCK

Fig.3B   DATA LAGS REF. CLOCK

3

Fig. 4

Fig.5

Fig.6

Fig.7

DATA IN

DATA PULSE

CLOCK OUT

REF. COUNT   14 15 0 1 2 1 2 3 4 5 6 7 8 9 10 11 12 13 14 15 0 1 2 1 2 3 4 5 6 7 8 9 10 11 12 13 14 15 0 1 2 3 4 5 6 7 8 9

FLAG

STEP COUNT

PUMP

V.C.O. CONTROL VOLTAGE

NOMINAL CONTROL VOLTAGE

0 091 200

Fig.8A
ZONE 1

Fig8B
ZONE 2
(FLAG NOT SET)

Fig8C
ZONE 2
(FLAG SET)

Fig8D
ZONE 3

Fig8E
ZONES 4&5

8

## 0 091 200

**Fig 9A** — ZONE 1

DATA PULSE | COUNT 15 0 1 2 3 4 5 6 7 8 9 10 11 12 13 14 15 0 1 2 3 4 5 | CLOCK

**Fig 9B** — ZONE 2 (FLAG NOT SET)

DATA PULSE | COUNT 1 2 3 3 4 5 6 7 8 9 10 11 12 13 14 15 0 1 2 2 3 4 5 6 7 8 | CLOCK

**Fig 9C** — ZONE 2 (FLAG SET)

DATA PULSE | COUNT 1 2 3 4 5 6 7 8 9 10 11 12 13 14 15 0 1 2 3 3 4 5 6 7 8 | FLAG | CLOCK

**Fig 9D** — ZONE 3

DATA PULSE | COUNT 2 4 5 5 6 7 8 9 10 11 12 13 14 15 0 1 2 3 4 4 5 6 7 8 9 | CLOCK

**Fig 9E** — ZONES 4 & 5

DATA PULSE | COUNT 5 6 7 6 7 8 9 10 11 12 13 14 15 0 1 2 3 4 5 6 5 6 7 8 9 | CLOCK

9